# EUROPÄISCHE PATENTSCHRIFT

(11) **EP 2 054 772 B1**
(45) Veröffentlichungstag und Bekanntmachung des Hinweises auf die Patenterteilung: **12.03.2014**
(21) Anmeldenummer: 07856453.1
(22) Anmeldetag: 07.12.2007
(51) Int. Cl.: G03F 7/20, G02B 26/12

(54) **BELICHTUNGSANLAGE**
EXPOSURE APPARATUS
INSTALLATION D'ÉCLAIRAGE

(30) Priorität: 11.12.2006 DE 102006059818
(43) Veröffentlichungstag der Anmeldung: 06.05.2009
(73) Patentinhaber: KLEO Halbleitertechnik GmbH, 88069 Tettnang (DE)
(72) Erfinder: OPOWER, Hans, 82152 Krailling (DE)
(74) Vertreter: Hoeger, Stellrecht & Partner Patentanwälte
(86) Internationale Anmeldenummer: PCT/EP2007/010648
(87) Internationale Veröffentlichungsnummer: WO 2008/071347

(56) Entgegenhaltungen:
- DE-A1- 10 346 201
- DE-A1-102005 011 339
- US-A1- 2002 141 024
- US-A1- 2004 165 056
- US-A1- 2004 240 813

## Beschreibung

Die Erfindung betrifft eine Belichtungsanlage zum Erzeugen belichteter Strukturen in einer auf einem Objekt angeordneten fotosensitiven Schicht, umfassend einen das Objekt aufnehmenden Objektträger und eine Belichtungseinrichtung, wobei der Objektträger und die Belichtungseinrichtung in einer Vorschubrichtung relativ zueinander bewegbar sind und wobei mit der Belichtungseinrichtung quer zur Vorschubrichtung Belichtungsflecken positionsgesteuert auf der fotosensitiven Schicht erzeugbar sind, wobei die Belichtungseinrichtung mindestens eine Belichtungseinheit mit einer Reihe von in einer Reihenrichtung aufeinanderfolgend angeordneten Strahlungsaustrittsbereichen aufweist, aus denen Belichtungsstrahlen austreten, von denen mit jedem durch eine Abbildungsoptik geführt ein Belichtungsfleck auf der fotosensitiven Schicht erzeugbar ist und von denen jeder durch eine Ablenkeinheit in einer schräg zu der Vorschubrichtung verlaufenden Ablenkrichtung ablenkbar ist, so dass mit jedem Belichtungsstrahl in der Ablenkrichtung in einer Vielzahl von aufeinanderfolgenden Belichtungsfleckpositionen einander zumindest teilweise überlappende Belichtungsflecken erzeugbar sind.

Derartige Belichtungsanlagen sind zum Beispiel aus der DE 103 46 201 A1 bekannt, wobei bei diesen Belichtungsanlagen die Aufgabenstellung darin besteht, mit möglichst hoher Präzision die fotosensitive Schicht zu belichten.

Ausgehend von diesen bekannten Lösungen liegt der vorliegenden Erfindung die Aufgabe zugrunde, eine Belichtungsanlage der gattungsgemäßen Art derart zu verbessern, dass eine möglichst hohe Belichtungsleistung zur Verfügung steht, das heißt eine möglichst große Zahl von Belichtungsflecken pro Zeiteinheit erzeugt werden kann.

Diese Aufgabe wird bei einer Belichtungsanlage der eingangs beschriebenen Art erfindungsgemäß dadurch gelöst, dass jeder Belichtungsfleck durch die Ablenkeinheit quer zu der Reihenrichtung ablenkbar ist, und dass der Belichtungsfleck der letzten Belichtungsfleckposition der einen Ablenkungsstrecke und der Belichtungsfleck der ersten Belichtungsfleckposition der nächstfolgenden Ablenkungsstrecke derart bezüglich einer parallel zur Vorschubrichtung verlaufenden Referenzgerade angeordnet sind, dass die Referenzgerade die in diesen Belichtungsfleckpositionen erzeugten Belichtungsflecken schneidet.

Der Vorteil der erfindungsgemäßen Lösung ist darin zu sehen, dass mit einer derartigen Belichtungsanlage gleichzeitig eine hohe Zahl von Belichtungsflecken erzeugt werden kann, deren Belichtungsfleckposition einerseits durch die Ablenkeinheit und andererseits durch die Bewegung in Vorschubrichtung definierbar ist.

Da bei dieser Lösung die Ablenkrichtung schräg zur Vorschubrichtung verläuft, besteht die Möglichkeit, trotz der quer zur Reihenrichtung verlaufenden Ablenkrichtung gleichzeitig durch die verschiedenen Belichtungsstrahlen der mindestens einen Belichtungseinheit quer zur Vorschubrichtung nebeneinanderliegende Belichtungsflecken zu belichten.

Dadurch, dass der Belichtungsfleck der letzten Belichtungsfleckposition der einen Ablenkungsstrecke und der Belichtungsfleck der ersten Belichtungsfleckposition der in der Reihenrichtung nächstfolgenden Ablenkungsstrecke derart bezüglich einer parallel zur Vorschubrichtung verlaufenden Referenzgerade angeordnet sind, dass die Referenzgerade die in diesen Belichtungsfleckpositionen erzeugten Belichtungsflecken schneidet, sind die von verschiedenen Belichtungsstrahlen erzeugten Belichtungsflecken so positionierbar, dass mit den Belichtungsflecken verschiedener Belichtungsstrahlen zusammenhängende Strukturen, insbesondere mit einer Komponente in einer Querrichtung, erzeugbar sind.

Durch diese Bedingung ist sichergestellt, dass die Belichtungsflecken der letzten Belichtungsfleckposition des einen Belichtungsstrahls und der ersten Belichtungsfleckposition des in der Reihenrichtung nächstfolgenden Belichtungsstrahls so relativ zueinander quer zur Vorschubrichtung angeordnet sind, dass diese bei geeigneter Verschiebung in Vorschubrichtung zumindest geringfügig überlappen.

Besonders günstig ist es ferner, wenn die Belichtungsflecken aufeinanderfolgender Belichtungsstrahlen der mindestens einen Belichtungseinheit längs zueinander paralleler Ablenkrichtungen bewegbar sind, da damit eine einfache gleichzeitige Positionierung der von den verschiedenen Belichtungsstrahlen erzeugbaren Belichtungsflecken realisierbar ist.

Ferner ist es günstig, wenn die Belichtungsstrahlen der mindestens einen Belichtungseinheit gleichzeitig und in gleichem Maße durch die Ablenkeinheit ablenkbar sind, so dass dadurch die Positionierung der von diesen Belichtungsstrahlen erzeugten Belichtungsflecken vereinfacht wird, da für eine Steuereinheit die Relativposition der Belichtungsflecken definiert festliegt.

Um auch die fotochemischen Prozesse in der fotosensitiven Schicht möglichst in gleichem Maße zu beeinflussen und auch bei allen Belichtungsstrahlen möglichst identische fotochemische Umwandlungsprozesse zu erhalten, ist vorzugsweise vorgesehen, dass die Belichtungsstrahlen einer Belichtungseinheit im Wesentlichen parallel zueinander ausgerichtet auf die fotosensitive Schicht auftreffen, so dass durch die Ausrichtung der Belichtungsstrahlen keine unterschiedlichen Wirkungen auftreten können.

Ferner ist es günstig, wenn die Bewegung jedes durch einen Belichtungsstrahl erzeugten Belichtungsflecks in der jeweiligen Ablenkrichtung über eine Ablenkungsstrecke erfolgt, die für jeden Belichtungsstrahl der Belichtungseinheit ungefähr gleich groß ist. Damit lässt sich in einfacher Weise die Positionierung der Belichtungsflecken mittels der Steuereinheit festlegen und durchführen.

Besonders günstig ist es, wenn eine parallel zur Vorschubrichtung verlaufende Referenzgerade durch die letzte Belichtungsfleckposition einer Ablenkungsstrecke den Belichtungsfleck einer ersten Belichtungsfleckposition einer nächstfolgenden Ablenkungsstrecke schneidet.

Durch diese Bedingung ist - wenn man davon ausgeht, dass als Belichtungsfleckposition ein Mittelpunkt des jeweiligen Belichtungsflecks anzunehmen ist - sichergestellt ist, dass sich die beiden Belichtungsflecken bei geeigneter Verschiebung in der Vorschubrichtung ungefähr mindestens zur Hälfte überlappen, eine Bedingung, die dann vorteilhaft ist, wenn über die Belichtungsflecken verschiedener Ablenkungsstrecken hinweg eine zusammenhängende Struktur in der fotosensitiven Schicht erzeugt werden soll.

Noch günstiger ist es, wenn die erste Belichtungsfleckposition der nächstfolgenden Ablenkungsstrecke einen Abstand von der Referenzgerade aufweist, der maximal einem halben Durchmesser des Belichtungsflecks entspricht, so dass die Überlappung der beiden Belichtungsflecken noch größer ist, das heißt mindestens die Hälfte des Durchmessers, üblicherweise jedoch mehr als diese beträgt.

Um im Rahmen der erfindungsgemäßen Lösung möglichst viele Belichtungsflecken gleichzeitig erzeugen zu können, ist vorzugsweise vorgesehen, dass mehrere Belichtungseinheiten vorgesehen sind, wobei die Belichtungseinheiten in der Ablenkrichtung im Abstand voneinander angeordnet sind.

Ferner ist bei derartigen mehreren Belichtungseinheiten vorgesehen, dass die Ablenkrichtungen der mehreren Belichtungseinheiten parallel zueinander verlaufen, so dass dadurch für die Steuereinheit die Festlegung der einzelnen Belichtungsfleckpositionen einfacher und effizienter durchführbar ist.

Die mehreren Belichtungseinheiten könnten so relativ zueinander angeordnet sein, dass die Reihenrichtungen aufeinanderfolgender Belichtungseinheiten quer zueinander verlaufen.

Ferner ist bei einem Ausführungsbeispiel vorgesehen, dass die Reihenrichtung der mehreren Belichtungseinheiten im Wesentlichen parallel zueinander verlaufen, so dass letztlich auch die einzelnen Reihen in den mehreren Belichtungseinheiten im Wesentlichen parallel zueinander ausgerichtet sind.

Um auch bei mehreren Belichtungseinheiten zusammenhängende Strukturen mit den durch diese erzeugbaren Belichtungsflecken erzeugen zu können, ist vorgesehen, dass die mehreren Belichtungseinheiten bezüglich einer parallel zur Vorschubrichtung verlaufenden Referenzgerade so angeordnet sind, dass die Referenzgerade den Belichtungsfleck der letzten Belichtungsfleckposition der letzten Ablenkungsstrecke einer Belichtungseinheit und den Belichtungsfleck der ersten Belichtungsfleckposition der ersten Belichtungsflecke der in Ablenkrichtung oder in Querrichtung nächstfolgenden Belichtungseinheit schneidet. Auch dadurch ist zumindest eine geringfügige Überlappung der beiden Belichtungsflecken sichergestellt, um mit den Belichtungsflecken verschiedener Belichtungseinheiten mit mindestens einer Komponente in der Querrichtung verlaufende und zusammenhängende Strukturen erzeugen zu können.

Noch besser ist die Überlappung jedoch dann, wenn die durch die letzte Belichtungsfleckposition einer letzten Ablenkstrecke einer Belichtungseinheit verlaufende Referenzgerade den Belichtungsfleck der ersten Belichtungsfleckposition einer ersten Ablenkstrecke einer in Ablenkrichtung oder Querrichtung nächstfolgenden schneidet, so dass ausgehend von der Tatsache, dass die Belichtungsfleckposition durch den Mittelpunkt des jeweiligen Belichtungsflecks definiert ist, die beiden Belichtungsflecken sich mindestens ungefähr zur Hälfte überlappen.

Eine weitere, für die Überlappung zweckmäßige Bedingung sieht vor, dass die erste Belichtungsfleckposition einen Abstand von der Referenzgerade aufweist, der maximal dem halben Durchmesser des Belichtungsflecks der ersten Belichtungsfleckposition entspricht.

Hinsichtlich der Ablenkeinheiten wurden bislang keine näheren Angaben gemacht.

Im Rahmen der erfindungsgemäßen Lösung wäre es grundsätzlich denkbar, für jeden Belichtungsstrahl eine eigene Ablenkeinheit vorzusehen, wobei die Ablenkeinheiten auch unterschiedlich arbeiten könnten.

Als, aus Gründen der Herstellung einer derartigen Belichtungsanlage günstige Lösung ist vorgesehen, dass die Ablenkeinheit für jeden der Belichtungsstrahlen einen Spiegelflächenbereich aufweist.

Dabei können die einzelnen Spiegelflächenbereiche immer noch unabhängig voneinander bewegbar sein. Aus Gründen einer konstruktiven Vereinbarung ist es jedoch günstig, wenn die Spiegelflächenbereiche einer Belichtungseinheit gemeinsam bewegbar sind.

Besonders günstig lassen sich die Spiegelflächenbereiche realisieren, wenn die Spiegelflächenbereiche Teilbereiche einer gemeinsamen Spiegelfläche sind.

Um mit diesen Spiegelflächenbereichen eine Ablenkung zu erreichen, ist es günstig, wenn die Spiegelflächenbereiche relativ zur Auftreffrichtung der Belichtungsstrahlen auf diese verkippbar sind, da eine derartige Kippbewegung der Spiegelflächenbereiche in einfacher Weise mechanisch realisierbar ist.

Grundsätzlich können die Spiegelflächenbereiche gewölbt sein, um mit diesen beispielsweise gleichzeitig noch eine Fokussierung durchführen zu können, konstruktiv besonders einfach ist jedoch eine Lösung, bei welcher die Spiegelflächenbereiche ebene Flächenbereiche sind.

Konstruktiv besonders günstig ist es, wenn alle Spiegelflächenbereiche in einer gemeinsamen Ebene liegen, die die Durchführung der Kippbewegung vereinfacht.

Bei dieser Lösung ist es insbesondere günstig, die Spiegelflächenbereiche so anzuordnen, dass die Spiegelflächenbereiche, auf die die Belichtungsstrahlen einer Belichtungseinheit auftreffen, in derselben Ebene liegen.

Um eine möglichst effiziente Ablenkung des jeweiligen Belichtungsstrahls zu erreichen, ist vorgesehen, dass die Belichtungseinheit für jeden Belichtungsstrahl mehrere Spiegelflächenbereiche aufweist.

Dabei ist es besonders günstig, wenn die Ablenkeinheit für jeden Belichtungsstrahl mehrere nacheinander zur Ablenkung des Belichtungsstrahls eingesetzte Spiegelflächenbereiche aufweist, so dass jeder Belichtungsstrahl durch eine Vielzahl aufeinanderfolgend zum Einsatz kommender Spiegelflächenbereiche abgelenkt wird.

Eine derartige Anzahl mehrerer Spiegelflächenbereiche lässt sich konstruktiv einfach dann realisieren, wenn die mehreren Spiegelflächenbereiche durch Umfangsseiten eines drehbar angeordneten Spiegelkörpers gebildet sind.

Der Spiegelkörper könnte dabei immer noch um eine Achse oszillierend kippbar sein.

Besonders günstig ist es jedoch, um eine möglichst hohe Ablenkgeschwindigkeit zu erreichen, wenn der Spiegelkörper um eine Achse rotierend angeordnet ist.

In diesem Fall sind zweckmäßigerweise die Spiegelflächenbereiche im gleichen radialen Abstand um die Achse angeordnet, wobei sich die Spiegelflächenbereiche vorzugsweise parallel zur Achse erstrecken.

Dabei könnten die Spiegelflächenbereiche auch gekrümmte Spiegelflächen aufweisen, die jedoch trotz Krümmung parallel zur Achse verlaufen.

Um definiert die Position der Spiegelflächen jeweils entsprechenden Belichtungsfleckpositionen zuordnen zu können, ist vorzugsweise vorgesehen, dass der Spiegelkörper mit konstanter Drehzahl um seine Achse rotiert.

Im Rahmen der erfindungsgemäßen Lösung wurden keine näheren Angaben darüber gemacht, wie die aus den Strahlungsaustrittsbereichen austretenden Belichtungsstrahlen erzeugt werden sollen. Beispielsweise können die Strahlungsaustrittsbereiche unmittelbar Austrittsbereiche von Strahlungsquellen, beispielsweise Laserdioden, sein.

Noch vorteilhafter ist es jedoch, wenn die Strahlungsaustrittsbereiche Enden von Lichtleitfasern sind.

Damit besteht die Möglichkeit, die Strahlungsbereiche und die Strahlungsquellen getrennt voneinander anzuordnen.

Um jedoch die Intensität in jedem einzelnen Strahlungsbereich gezielt steuern zu können, ist vorgesehen, dass jeder Lichtleitfaser eine eigene Strahlungsquelle zugeordnet ist, so dass durch die Intensitätssteuerung dieser Strahlungsquelle, sei es durch Intensitätssteuerung der Strahlungsquelle selbst oder eines nachfolgenden Intensitätssteuerungselements, die aus den Strahlungsaustrittsbereichen austretende Intensität steuerbar ist.

Vorzugsweise ist dabei als Strahlungsquelle ebenfalls ein Laser vorgesehen, der aus Gründen eines einfachen Aufbaus vorzugsweise ein Halbleiterlaser ist. Besonders günstig ist es dabei, wenn die Strahlungsquellen in einer von der Belichtungseinrichtung getrennt angeordneten Strahlungserzeugungseinheit angeordnet sind, da dann die Möglichkeit besteht, die Strahlungsquellen effizient zu kühlen und insbesondere nicht die Gefahr besteht, das aufgrund der von den Strahlungsquellen entwickelten Wärme thermische Probleme hinsichtlich der Genauigkeit der von der Belichtungseinrichtung erzeugbaren Belichtungsfleckpositionen entstehen.

Weitere Merkmale und Vorteile der erfindungsgemäßen Lösung sind Gegenstand der nachfolgenden Beschreibung sowie der zeichnerischen Darstellung eines Ausführungsbeispiels.

In der Zeichnung zeigen:
- Fig. 1: eine schematische perspektivische Darstellung eines Ausführungsbeispiels einer erfindungsgemäßen Belichtungsanlage;
- Fig. 2: eine ausschnittsweise vergrößerte Darstellung eines auf einem Objektträger angeordneten Objekts mit einer fotosensitiven Schicht und gegebenenfalls in dieser zur erzeugenden Strukturen;
- Fig. 3: eine schematische ausschnittsweise Darstellung eines Teilbereichs eines Belichtungsbereichs, in welchem Belichtungsflecken erzeugbar sind;
- Fig. 4: eine ausschnittsweise schematische Darstellung zweier Belichtungseinheiten;
- Fig. 5: eine Draufsicht in Richtung eines Pfeils A auf eine der Belichtungseinheiten;
- Fig. 6: eine vergrößerte ausschnittsweise Darstellung von von zwei Belichtungsstrahlen erzeugbaren Belichtungsfleckpositionen und Belichtungsflecken;
- Fig. 7: eine schematische vergrößerte Darstellung des Wanderns eines Belichtungsstrahls in Ablenkrichtung und
- Fig. 8: eine schematische vergrößerte Darstellung von nebeneinanderliegend angeordneten Belichtungseinheiten der Belichtungseinrichtung in einem Schnitt längs Linie 8-8 in Fig. 1.

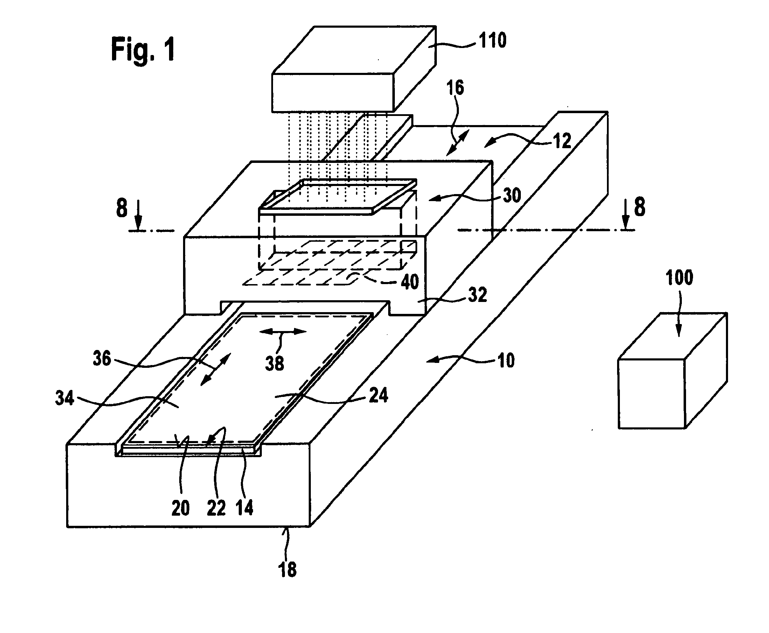

Ein Ausführungsbeispiel einer in Fig. 1 dargestellten Belichtungseinrichtung umfasst eine als Ganzes mit 10 bezeichnete Maschinenbasis, welche eine Führung 12 aufweist, längs welcher ein Objektträger 14 in Richtung einer Vorschubrichtung 16 einerseits bewegbar geführt ist und andererseits durch Antriebe, beispielsweise Linearantriebe, vorzugsweise positionsgenau bewegbar ist.

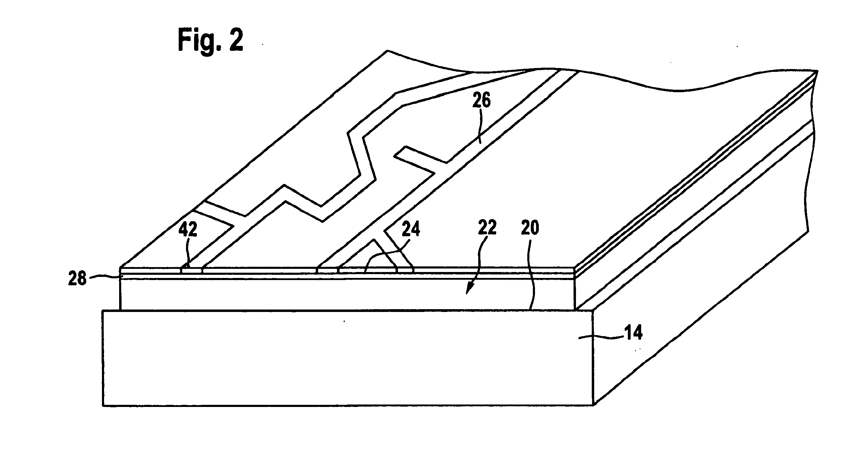

Die Führung 12 ist dabei beispielsweise auf einer einer Standfläche 18 abgewandten Seite der Maschinenbasis 10 angeordnet und führt den Objektträger 14 derart, dass auf dessen der Maschinenbasis 10 abgewandter Oberseite 20, wie in Fig. 2 dargestellt, ein Objekt 22 auflegbar und fixierbar ist, das auf seiner dem Objektträger 14 wiederum abgewandten Seite mit einer fotosensitiven Schicht 24 versehen ist, in welcher durch eine geeignete Belichtung Strukturen 26 durch optische Umwandlung des Materials der fotosensitiven Schicht 24 erzeugbar sind.

Beispielsweise dienen derartige Strukturen 26 dazu, einzelne Bereiche einer Schicht 28, beispielsweise einer Kupferschicht 28 des Objekts 22 selektiv abzudecken, um dann im Rahmen beispielsweise eines Ätzvorgangs die Schicht 28 an den Stellen, an denen sie nicht durch die Strukturen 26 abgedeckt ist, abzutragen, so dass die Schicht 28 lediglich in den Bereichen, in denen sie durch die Strukturen 26 abgedeckt ist, bestehen bleibt.

Das Herstellen der in Fig. 2 dargestellten Strukturen 26 durch optische Umwandlung der fotosensitiven Schicht 24 erfolgt durch eine als Ganzes mit 30 bezeichnete Belichtungseinrichtung, die an einer Brücke 32 angeordnet ist, welche sich beidseits der Führung 12 auf der Maschinenbasis 10 abstützt und sich im Übrigen über die Führung 12 hinwegerstreckt.

Bei dem dargestellten Ausführungsbeispiel ist es mit der erfindungsgemäßen Belichtungseinrichtung 30 möglich, bei einer einmaligen Bewegung des Objektträgers 14 mit dem Objekt 22 mit der fotosensitiven Schicht 24 die fotosensitive Schicht im Zuge einer einmaligen Bewegung der fotosensitiven Schicht 24 in der Vorschubrichtung 16 innerhalb eines Strukturenbereichs 34 alle in diesem Strukturenbereich 34 vorgesehenen Strukturen 26 durch Belichtung herzustellen, wobei die Belichtungseinrichtung 30 in der Lage ist, im Zuge der einmaligen Bewegung der fotosensitiven Schicht 24 und der Vorschubrichtung 16 den Strukturenbereich 34 sowohl in seiner Längsrichtung 36 als auch in seiner Querrichtung 38 in einem Zuge zu belichten, um sämtliche innerhalb des Strukturenbereichs 34 vorgesehenen und geforderten Strukturen 26 herzustellen, ohne dass es weiterer Bewegungen des Objektträgers 14 in der Vorschubrichtung 16 bedarf.

Es ist aber auch bei einer Abwandlung des ersten Ausführungsbeispiels denkbar, den Objektträger 14 einmal in einer Richtung der Vorschubrichtung 16 zu bewegen und ein andermal entgegengesetzt hierzu, so dass ausgehend von einer in Fig. 1 dargestellten Ausgangsstellung eine Hin- und Zurückbewegung des Objektträgers 14 zur gewünschten umfassenden Belichtung im Strukturenbereich 34 führt, so dass es beispielsweise denkbar wäre, im Zuge einer Bewegung in einer Richtung der Vorschubrichtung 16 in der Querrichtung 38 gesehen die Hälfte des Strukturenbereichs 34 zu belichten und gegebenenfalls im Gegenzug dazu die andere Hälfte.

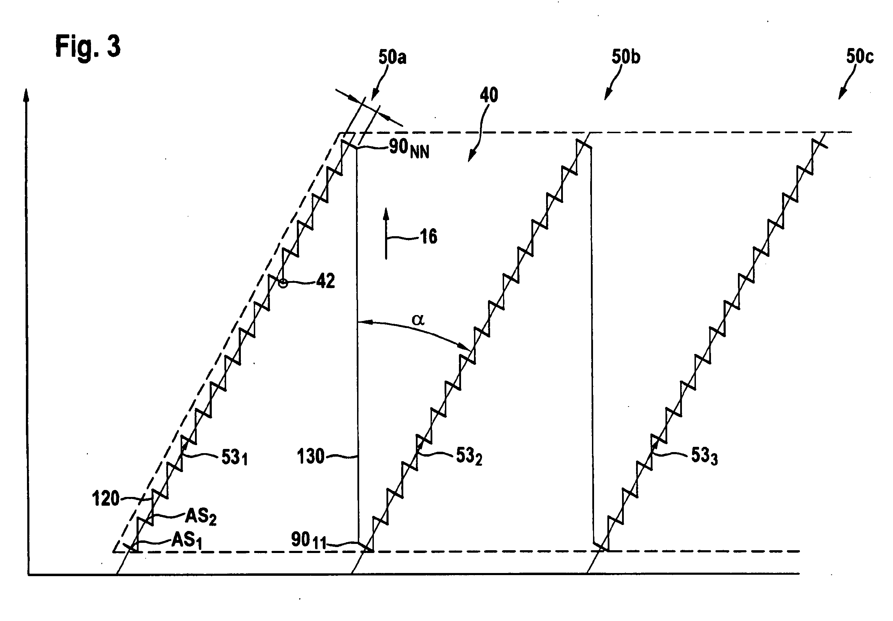

Um innerhalb dieses Strukturenbereichs 34 alle erforderlichen Strukturen 26 erzeugen zu können, sind innerhalb eines Belichtungsbereichs 40, dargestellt in Fig. 1 und teilweise in Fig. 3 einzelne Belichtungsflecken 42 erzeugbar, welche derart innerhalb des Belichtungsbereichs 40 angeordnet sind, dass die Summe aller in dem Belichtungsbereich 40 vorhandenen Belichtungsflecken 42 all diejenigen Belichtungsflecken 42 umfasst, die erforderlich sind, um in der Querrichtung 38 eine sich über die gesamte Ausdehnung des Strukturenbereichs 34 in der Querrichtung 38 erstreckende linienförmige Struktur zu erzeugen, die in der Querrichtung 38 ununterbrochen durchgängig ist, wozu die Belichtungsflecken 42 so anzuordnen sind, dass diese sich in der Querrichtung 38 aufeinanderfolgende Belichtungsflecken 42 überlappen.

Das heißt mit anderen Worten, dass die innerhalb des Belichtungsbereichs 40 erzeugbaren Belichtungsflecken 42 eine derartige Größe haben und derart angeordnet sind, dass mit diesen unter Berücksichtigung der Bewegung des Objekts 22 in der Vorschubrichtung 16 flächendeckend im gesamten Strukturbereich 34 der fotosensitiven Schicht 24 im Rahmen der durch die flächenhafte Ausdehnung der Belichtungsflecken 42 in der Längsrichtung 36 und der Querrichtung 38 bedingten Auflösung sämtliche mögliche Strukturen 26 erzeugbar sind.

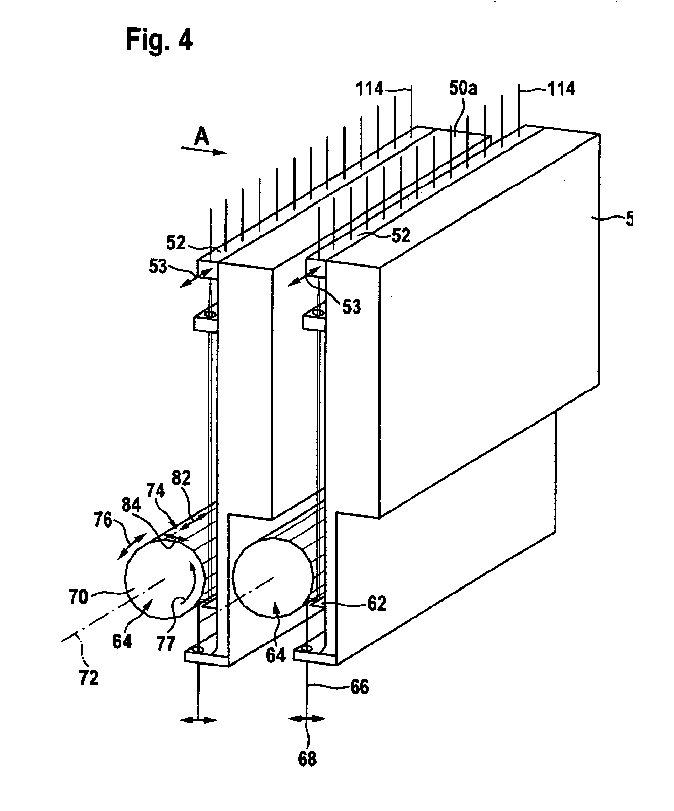

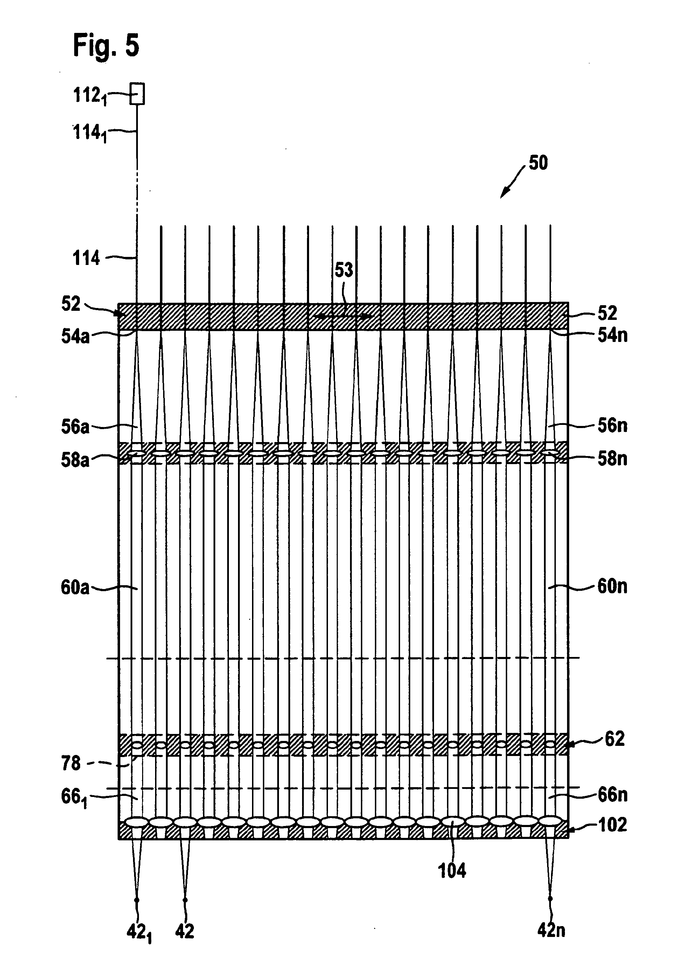

Um innerhalb des Belichtungsbereichs 40 die Belichtungsflecken 42 mit der erforderlichen Anzahl und Lage erzeugen zu können, sind, wie in Fig. 4 dargestellt, in der Belichtungseinrichtung 30 mehrere Belichtungseinheiten 50 vorgesehen, von denen jede, wie in Fig. 5 dargestellt, eine Reihe von in einer Reihenrichtung 53 aufeinanderfolgend und im Abstand voneinander angeordnete Strahlungsaustrittsbereichen 54 aufweist, aus denen jeweils Belichtungsstrahlen 56 austreten, die durch Optiken 58 in kollimierte Belichtungsstrahlen 60 umgeformt werden, wobei dann die kollimierten Belichtungsstrahlen 60, wie in Fig. 4 und 5 dargestellt, durch eine Umlenkeinheit 62 quer zu ihrer Ausbreitungsrichtung umgelenkt werden und dabei auf eine in Fig. 4 dargestellte Ablenkeinheit 64 treffen, die, wie in Fig. 4 dargestellt, die kollimierten Belichtungsstrahlen 60 in in einer Ablenkrichtung 68 quer zu einer Richtung 53 wandernde Belichtungsstrahlen 66 umlenkt.

Die Ablenkeinheit 64 umfasst einen Spiegelkörper 70, der symmetrisch zu einer Achse 72 angeordnete und sich parallel zur Achse 72 erstreckende Spiegelflächen 74 aufweist, die vorzugsweise mantelseitig des Spiegelkörpers 70 angeordnet sind.

Vorzugsweise grenzen die Spiegelflächen 74 in Umfangsrichtung 76 im Wesentlichen aneinander an und erstrecken sich in ihrer Längsrichtung 82 sowie in ihrer Querrichtung 84 über dieselbe Länge bzw. Breite, so dass alle Spiegelflächen 74 dieselbe Ausdehnung aufweisen.

Darüber hinaus sind alle Spiegelflächen 74 ebene Flächen, so dass der Spiegelkörper 70 im einfachsten Fall eine Querschnittsfläche aufweist, die die eines regelmäßigen Vielecks ist, wobei die Zahl der Spiegelflächen 74 beispielsweise größer als 4 und kleiner als 40 ist.

Eine bevorzugte Ausführung sieht vor, dass die Zahl der Spiegelflächen 74 größer als 12 und kleiner als 30 ist.

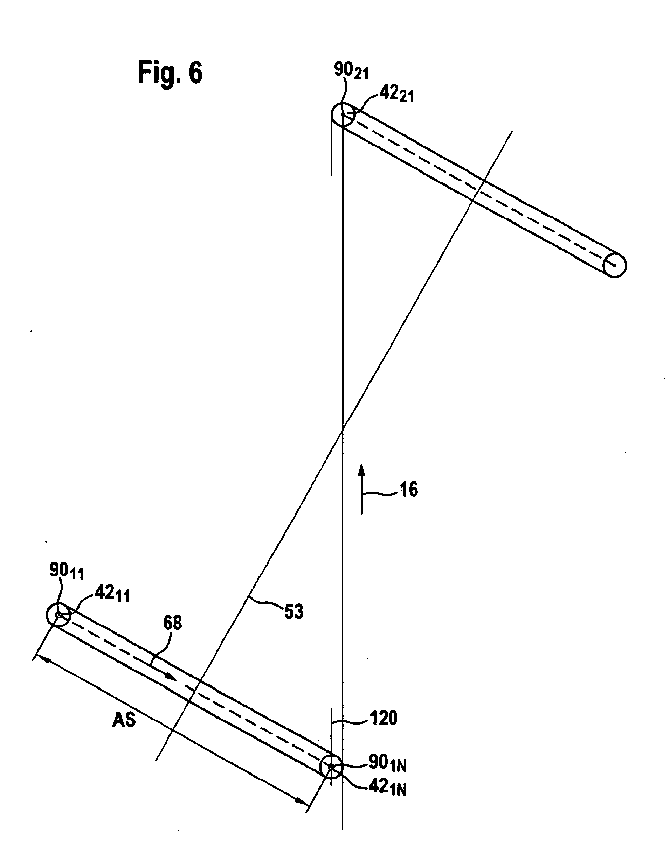

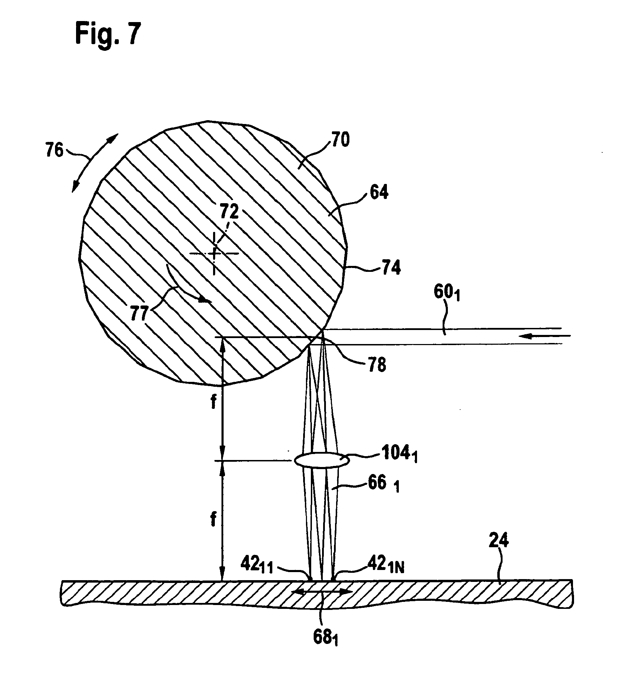

Jede der Spiegelflächen 74 reflektiert mit jeweils einem Spiegelflächenbereich 78 jeweils einen von der Umlenkeinheit 62 umgelenkten kollimierten Belichtungsstrahl 60 entsprechend der jeweiligen Drehstellung des Spiegelkörpers 70 derart, dass, wie in Fig. 6 und 7 dargestellt, in einer ersten Stellung der Spiegelfläche 74 der wandernde Belichtungsstrahl 66₁ einen Belichtungsfleck 42₁₁ in einer ersten Belichtungsfleckposition 90_{1N}, erzeugt, der dann in Richtung der Ablenkrichtung 68 über eine Ablenkungsstrecke AS weiter wandern kann bis zu einer letzten Belichtungsfleckposition 90_{N}, die der Stellung der jeweiligen Spiegelfläche 74 entspricht, in welcher der Belichtungsstrahl 60₁ noch auf diese auftrifft und somit noch von dieser zur Erzeugung des der letzten Belichtungsfleckposition 90_{1N} zugeordneten Belichtungsflecks 42 dient.

Ein Weiterdrehen des Spiegelkörpers 70 in der Drehrichtung 77 führt dann dazu, dass der Belichtungsstrahl 60₁ auf die nächste Spiegelfläche 74 auftrifft, die dann den Belichtungsstrahl 60₁ wiederum so in den wandernden Belichtungsstrahl 66₁ reflektiert, dass dieser wiederum den Belichtungsfleck 42₁₁ in der ersten Belichtungsfleckposition 90₁₁ erzeugt.

Somit führt die ständige Rotation des Spiegelkörper 70 um die Achse 72 zu einer ständigen Wanderung der Belichtungsflecken 42₁ von der ersten Belichtungsfleckposition 90₁ bis zur letzten Belichtungsfleckposition 90_{1N} über die Ablenkungsstrecken AS auf der fotosensitiven Schicht 24.

Damit besteht die Möglichkeit, im Bereich der Ablenkungsstrecke AS längs der Ablenkrichtung 68 durch die Belichtungsflecken 42 in definiert wählbaren Belichtungsfleckpositionen 90₁ eine Belichtung der fotosensitiven Schicht 24 durchzuführen, und zwar dann, wenn der jeweilige Belichtungsfleck 42 in der jeweiligen Belichtungsfleckposition 90₁ steht, wobei nur in dieser Stellung auf der fotosensitiven Schicht 24 durch Aktivieren des jeweiligen Belichtungsstrahls 66₁, das heißt beispielsweise Einschalten der dem Strahlungsaustritt 54₁ zugeordneten Strahlungsquelle, eine Belichtung mit ausreichender Intensität erfolgt, durch welche eine fotochemische Umwandlung in der fotosensitiven Schicht im Bereich dieses Belichtungsflecks 42₁ erreichbar ist.

Ist in den übrigen Belichtungsfleckpositionen 90₁ innerhalb der Ablenkungsstrecke AS keine Belichtung der fotosensitiven Schicht 24 vorgesehen, so wird die dem jeweiligen Strahlungsaustritt 54₁ zugeordnete Strahlungsquelle beim Durchlaufen dieser Belichtungsfleckpositionen 90₁ nicht eingeschaltet oder mit einer Intensität betrieben, die zu keiner fotochemischen Umwandlung der fotosensitiven Schicht 24 im Bereich des jeweiligen Belichtungsflecks 42₁ führen kann.

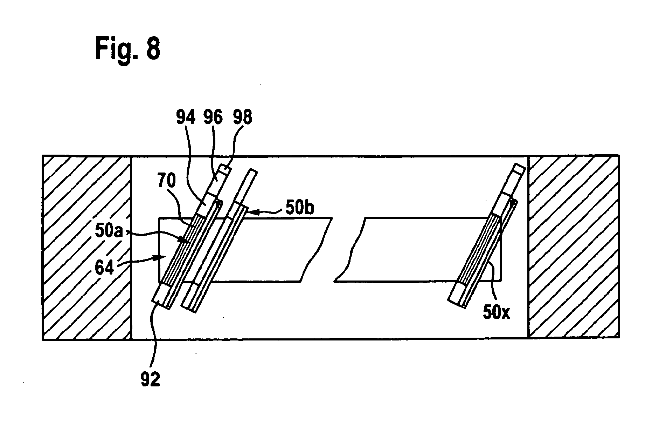

Die Spiegelkörper 70 der Ablenkeinheiten 64 sind hierzu, wie in Fig. 8 dargestellt, beidseitig durch Lagereinrichtungen 92 und 94 um die Achse 72 drehbar gelagert und außerdem durch einen Antrieb 96 mit konstanter Geschwindigkeit rotierend angetrieben, wobei jedem Antrieb 96 noch ein Sensor 98 zugeordnet ist, welcher in der Lage ist, die Drehstellung des Spiegelkörpers 70 und somit insbesondere die Stellung der Spiegelflächen 74 für eine als Ganzes mit 100 bezeichnete Steuereinheit zu erfassen, die die Belichtung steuert.

Zur Fokussierung der wandernden Belichtungsstrahlen 66 auf die fotosensitive Schicht 24 und somit zur Einstellung der Ausdehnung der von den jeweiligen Belichtungsstrahlen 66 erzeugten Belichtungsflecken 42 ist zwischen der Ablenkeinheit 64 und der fotosensitiven Schicht 24 noch eine optische Einheit 102 vorgesehen, welche für jeden der Belichtungsstrahlen 66 eine eigene Abbildungsoptik 104, beispielsweise in Form einer Linse, aufweist, durch welche der jeweilige wandernde Belichtungsstrahl 66 hindurchtritt und damit auf den jeweiligen Belichtungsfleck 42 mit einer definierten Größe des Belichtungsflecks 42 sowie einer definierten Intensitätsverteilung im Belichtungsfleck 42 auf die fotosensitive Schicht 24 fokussiert wird.

Insbesondere sind vorteilhafte Abbildungseigenschaften der Abbildungsoptik 104 dann gegeben, wenn der mittlere Abstand zwischen dem wirksamen Spiegelflächenbereich 78 der Spiegelfläche 74 ungefähr der Brennweite f der Abbildungsoptik 104 entspricht, so dass die Abbildungsverhältnisse für den wandernden Belichtungsstrahl im Wesentlichen identisch sind und somit auch die Belichtungsflecken 42 im Wesentlichen dieselbe Größe und im Wesentlichen dieselbe Intensitätsverteilung aufweisen (Fig. 7).

Ferner ist vorzugsweise vorgesehen, dass auch der Abstand zwischen der Abbildungsoptik 104 und der zu belichtenden fotosensitiven Schicht 24 ungefähr der Brennweite f der Abbildungsoptik 104 entspricht (Fig. 7), um eine optimale Fokussierung des jeweiligen Belichtungsstrahls 66 im Belichtungsfleck 42 auf der fotosensitiven Schicht 24 zu erhalten.

Hinsichtlich der Erzeugung der Belichtungsstrahlen 56 wurden bislang keinerlei nähere Angaben gemacht.

Vorzugsweise ist zur Erzeugung der Belichtungsstrahlen 56 separat von der Belichtungseinrichtung 30 eine Strahlungserzeugungseinheit 110 vorgesehen, welche eine Vielzahl von Strahlungsquellen 112, beispielsweise Laserdioden, umfasst, wobei die von jeder der Strahlungsquellen 112 erzeugte Strahlung in einen Lichtleiter 114 eingekoppelt wird, der von der Strahlungserzeugungseinheit 110 zur Belichtungseinrichtung 30 verläuft und eine Endfläche aufweist, welche den Strahlungsaustrittsbereich 54 bildet, aus dem die Belichtungsstrahlen 56 austreten.

Die Anordnung der Strahlungserzeugungseinheit 110 getrennt von der Belichtungseinheiten 50 hat den Vorteil, dass damit die Möglichkeit besteht, die Strahlungsquellen 112 für deren Betrieb optimal anzuordnen und die von dieser erzeugte Wärme optimal abzuführen, ohne dass eine thermische Beeinflussung der Belichtungseinrichtung 30 damit verbunden sein könnte. Vielmehr ist die Belichtungseinrichtung 30 völlig von der Strahlungserzeugungseinheit 110 thermisch entkoppelt und somit besteht keine Gefahr einer Beeinträchtigung der Präzision im Bereich der Belichtungseinrichtung 30 aufgrund von thermischen, durch die Strahlungserzeugungseinheit 110 bedingten Effekten.

Die Strahlungserzeugungseinheit 110 kann dabei im Abstand über der Belichtungseinrichtung 30 angeordnet werden, es besteht aber auch die Möglichkeit bei ausreichend lang ausgeführten Lichtleitern 114 die Strahlungserzeugungseinheit 110 seitlich der Maschinenbasis 10, beispielsweise neben der Steuereinheit 100, anzuordnen.

Wie bereits dargelegt, besteht für die Strahlungserzeugungseinheit 110 die Möglichkeit, einerseits exakt die Drehstellung des Spiegelkörpers 70 über die jeweiligen, der jeweiligen Belichtungseinheit 64 zugeordneten Sensoren 98 zu erfassen und somit bestimmen zu können, in welcher Belichtungsfleckposition 90 der jeweilige erzeugte Belichtungsfleck 42 längs der Ablenkungsstrecke AS zu dem jeweils bestimmten Zeitpunkt steht und somit zu entscheiden, ob in dieser Belichtungsfleckposition 90 eine Belichtung der fotosensitiven Schicht 24 durchgeführt werden soll oder nicht, und entsprechend dieser Entscheidung die Strahlungsquelle 112, die für die Erzeugung des jeweiligen Belichtungsflecks 42 vorgesehen ist, so anzusteuern, dass diese Strahlung liefert, welche einen fotochemischen Effekt in der fotosensitiven Schicht 24 im Bereich des Belichtungsflecks 42 auslöst, oder abzuschalten oder hinsichtlich ihrer Intensität soweit zu verringern, dass kein fotochemischer Effekt im Bereich des in der jeweiligen Belichtungsfleckposition 90 stehenden Belichtungsflecks 42 auftritt.

Um nicht nur innerhalb der Ablenkungsstrecke AS die einzelnen Belichtungsflecken 42 in den einzelnen Belichtungsfleckpositionen 90 so positionieren zu können, dass diese - für die Herstellung zusammenhängender, sich mindestens mit einer Komponente in der Querrichtung erstreckender Strukturen 26 - einander überlappen, um die zusammenhängende Struktur 26 durch eine Vielzahl von einzelnen Belichtungsflecken 42 erzeugen zu können, sondern um auch die Belichtungsflecken 42, die durch in der Reihenrichtung 53 aufeinanderfolgende Belichtungsstrahlen 66 erzeugbar sind, überlappend anzuordnen, verläuft die Reihenrichtung 53 relativ zur Vorschubrichtung 16 in einem Winkel α so, dass eine zur Vorschubrichtung 16 parallele Referenzgerade 120 durch die letzte Belichtungsfleckposition 90_{1N} des beispielsweise ersten Belichtungsstrahls 66₁ einer Belichtungseinheit 50 den Belichtungsfleck 42₂₁ in der ersten Belichtungsfleckposition 90₂₁ des in der Reihenrichtung 53 nächstfolgenden Belichtungsstrahls 66₂ tangiert, vorzugsweise schneidet, so dass durch Bewegung des letzten Belichtungsflecks 42_{1N} in der Vorschubrichtung 16 bis zur Vorschubposition des ersten Belichtungsflecks 42₂₁ des nächstfolgenden Belichtungsstrahls 66₂ die beiden Belichtungsflecke 42_{1N} und 42₂₁ miteinander überlappend angeordnet werden können und somit auch die Belichtungsflecke 42₂ des zweiten Belichtungsstrahls 66₂ dazu herangezogen werden können, zusammen mit den Belichtungsflecken 42₁ des ersten Belichtungsstrahls 66₁ die zusammenhängende Struktur 26 zu erzeugen.

Diese relative Anordnung des jeweils letzten Belichtungsflecks 42 eines Belichtungsstrahls 66 zum jeweils ersten Belichtungsfleck 42 des nächstfolgenden Belichtungsstrahls 66 ist bei allen Belichtungsstrahlen 66 und Belichtungsflecken 42 einer Belichtungseinheit 50 vorgesehen, so dass theoretisch alle Belichtungsflecken 42 dieser Belichtungseinheit 50 dazu herangezogen werden können, eine sich mit einer Komponente in der Querrichtung 38 über die gesamte Ausdehnung dieser Belichtungseinheit 50 in der Querrichtung 38 erstreckende zusammenhängende Struktur 26 zu erzeugen.

In gleicher Weise wie im Zusammenhang mit der Anordnung der Belichtungsflecken 42, erzeugt durch verschiedene Belichtungsstrahlen 66 beschrieben, sind auch die mehreren Belichtungseinheiten 50a, 50b, 50c etc. so relativ zueinander angeordnet, dass, wie beispielsweise in Fig. 3 dargestellt, eine zur Vorschubrichtung 16 parallele Referenzgerade 120 durch die letzte Belichtungsposition 90_{NN} einer ersten Belichtungseinheit, beispielsweise der Belichtungseinheit 50a, den Belichtungsfleck 42₁₁ der ersten Belichtungsposition 90₁₁ der in der Querrichtung 38 nächstfolgenden Belichtungseinheit, beispielsweise der Belichtungseinheit 50b tangiert oder schneidet, so dass auch die von mehreren Belichtungseinheiten, beispielsweise den Belichtungseinheiten 50a und 50b erzeugbaren Belichtungsflecken zur Erzeugung einer zusammenhängenden Struktur 26 herangezogen werden können, dadurch, dass die Belichtungsflecken 42 einer Belichtungseinheit, beispielsweise der Belichtungseinheit 50a überlappend positioniert werden und der letzte Belichtungsfleck 42_{NN} des letzten Belichtungsstrahls 66_{N} überlappend mit dem ersten Belichtungsfleck 42₁₁ des ersten Belichtungsstrahls 66₁ der nächstfolgenden Belichtungseinheit, beispielsweise der Belichtungseinheit 50b, überlappend angeordnet werden kann.

Unter der Voraussetzung, dass sich der Belichtungsbereich 40 in der Querrichtung 38 über die gesamte Breite der fotosensitiven Schicht 24 oder zumindest über einen zur Belichtung und zur Erzeugung von Strukturen 26 vorgesehenen Bereich der fotosensitiven Schicht 24, erstreckt, sind in dem gesamten Bereich der fotosensitiven Schicht 24 zusammenhängende oder dann auch nicht zusammenhängende Strukturen 26 erzeugbar.

Da alle Belichtungseinheiten 50 der Belichtungseinrichtung 30 relativ zueinander derart angeordnet sind, besteht somit die Möglichkeit, auf der fotosensitiven Schicht 24 über deren gesamte Querrichtung 38 und über die gesamte Längsrichtung 36 unter Heranziehen der Vorschubbewegung 16 in beliebigen Bereichen zusammenhängende Strukturen 26 zu erzeugen, die sowohl in der Längsrichtung 36 als auch in der Querrichtung 38 oder in jedem Winkel zu diesen verlaufen können.

Hierzu erfasst die Steuereinheit 100 sowohl die Position der fotosensitiven Schicht 24 in der Vorschubrichtung 16 durch Detektion der Position des Objektträgers 14 sowie die Positionen der einzelnen erzeugbaren Belichtungsflecken 42 längs der Ablenkungsstrecke AS durch die Drehstellung der Spiegelkörper 70 und ist damit in der Lage, zusätzlich noch durch geeignete Ansteuerung der jeweiligen Strahlungsquelle 112 zum geeigneten Zeitpunkt an jeder Stelle des zur Belichtung vorgesehenen Bereichs der fotosensitiven Schicht 24 einen Belichtungsfleck 42 zu generieren, wobei dies vorzugsweise durch geeignete Ansteuerung der Strahlungsquellen 112 im Zuge einer einzigen Bewegung des Objektträgers 14 in der Vorschubrichtung erfolgt.

Für eine ausreichende Genauigkeit beim Positionieren der Belichtungsflecken 42 zur Erzeugung der Strukturen 26 ist es günstig, wenn die Geschwindigkeit in Vorschubrichtung 16 nur so groß ist, dass die von zwei in der Umfangsrichtung 76 aufeinanderfolgenden Spiegelflächenbereichen 78 durch einen Belichtungsstrahl 66 erzeugten Belichtungsflecken 42 maximal einen halben Durchmesser, noch besser um maximal einen Viertel- oder Fünfteldurchmesser der Belichtungsflecken 42 gegeneinander versetzt sind, das heißt in erheblichem Umfang überlappen.

## Patentansprüche

1. Belichtungsanlage zum Erzeugen belichteter Strukturen (26) in einer auf einem Objekt (22) angeordneten fotosensitiven Schicht (24), umfassend einen das Objekt (22) aufnehmenden Objektträger (14) und eine Belichtungseinrichtung (30), wobei der Objektträger (14) und die Belichtungseinrichtung (30) in einer Vorschubrichtung (16) relativ zueinander bewegbar sind und wobei mit der Belichtungseinrichtung (30) quer zur Vorschubrichtung (16) Belichtungsflecken (42) positionsgesteuert auf der fotosensitiven Schicht (24) erzeugbar sind, wobei die Belichtungseinrichtung (30) mindestens eine Belichtungseinheit (50) mit einer Reihe (52) von in einer Reihenrichtung (53) aufeinanderfolgend angeordneten Strahlungsaustrittsbereichen (54) aufweist, aus denen Belichtungsstrahlen (56) austreten, von denen mit jedem durch eine Abbildungsoptik (102) geführt ein Belichtungsfleck (42) auf der fotosensitiven Schicht (24) erzeugbar ist und von denen jeder durch eine Ablenkeinheit (64) in einer schräg zu der Vorschubrichtung (16) verlaufenden Ablenkrichtung (68) ablenkbar ist, so dass mit jedem Belichtungsstrahl (60) in der Ablenkrichtung (68) in einer Vielzahl von aufeinanderfolgenden Belichtungsfleckpositionen (90) einander zumindest teilweise überlappende Belichtungsflecken (42) erzeugbar sind,
**dadurch gekennzeichnet, dass** jeder Belichtungsfleck (42) durch die Ablenkeinheit quer zu der Reihenrichtung (53) ablenkbar ist, und dass der Belichtungsfleck (42) der letzten Belichtungsfleckposition (90) der einen Ablenkungsstrecke (AS) und der Belichtungsfleck (42) der ersten Belichtungsfleckposition (90) der nächstfolgenden Ablenkungsstrecke (AS) derart bezüglich einer parallel zur Vorschubrichtung (16) verlaufenden Referenzgerade (120) angeordnet sind, dass die Referenzgerade (120) die in diesen Belichtungsfleckpositionen (90) erzeugten Belichtungsflecken (42) schneidet.

2. Belichtungsanlage nach Anspruch 1, **dadurch gekennzeichnet, dass** die Belichtungsflecken (42) aufeinanderfolgender Belichtungsstrahlen (60) längs zueinander paralleler Ablenkrichtungen (68) bewegbar sind.

3. Belichtungsanlage nach einem der voranstehenden Ansprüche, **dadurch gekennzeichnet, dass** die Belichtungsstrahlen (60) der mindestens einen Belichtungseinheit (50) gleichzeitig und in gleichem Maße durch die Ablenkeinheit (64) ablenkbar sind.

4. Belichtungsanlage nach einem der voranstehenden Ansprüche, **dadurch gekennzeichnet, dass** die Belichtungsstrahlen (60) einer Belichtungseinheit (50) im Wesentlichen parallel zueinander ausgerichtet auf die fotosensitive Schicht (24) auftreffen.

5. Belichtungsanlage nach einem der voranstehenden Ansprüche, **dadurch gekennzeichnet, dass** die Bewegung jedes durch einen Belichtungsstrahl (66) erzeugten Belichtungsflecks (42) in der jeweiligen Ablenkrichtung (68) über eine Ablenkungsstrecke (AS) erfolgt, die für jeden Belichtungsstrahl (66) der Belichtungseinheit (50) ungefähr gleich groß ist.

6. Belichtungsanlage nach einem der voranstehenden Ansprüche, **dadurch gekennzeichnet, dass** eine parallel zur Vorschubrichtung (16) verlaufende Referenzgerade (120) durch die letzte Belichtungsfleckposition (90) einer Ablenkungsstrecke (AS) den Belichtungsfleck (42) einer ersten Belichtungsfleckposition (90) einer nächstfolgenden Ablenkungsstrecke (AS) schneidet.

7. Belichtangsanlage nach Anspruch 6, **dadurch gekennzeichnet, dass** die erste Belichtungsfleckposition (90) der nächstfolgenden Ablenkungsstrecke (AS) einen Abstand von der Referenzgerade (120) aufweist der maximal einem halben Durchmesser des Belichtungsflecks (42) entspricht.

8. Belichtungsanlage nach einem der voranstehenden Ansprüche, **dadurch gekennzeichnet, dass** mehrere Belichtungseinheiten (50) vorgesehen sind, wobei die Belichtungseinheiten (50) in der Ablenkrichtung (68) im Abstand voneinander angeordnet sind.

9. Belichtungsanlage nach Anspruch 8, **dadurch gekennzeichnet, dass** die Ablenkrichtungen (68) der mehreren Belichtungseinheiten (50) im Wesentlichen parallel zueinander verlaufen.

10. Belichtungsanlage nach Anspruch 8 oder 9, **dadurch gekennzeichnet, dass** die Reihenrichtungen (53) der mehreren Belichtungseinheiten (50) im Wesentlichen parallel zueinander verlaufen.

11. Belichtungsanlage nach einem der Ansprüche 8 bis 10, **dadurch gekennzeichnet, dass** die mehreren Belichtungseinheiten (50) bezüglich einer parallel zur Vorschubrichtung (16) verlaufenden Referenzgerade (120) so angeordnet sind, dass die Referenzgerade (120) den Belichtungsfleck (42) der letzten Belichtungsfleckposition (90) der letzten Ablenkungsstrecke (AS) einer Belichtungseinheit (50) und den Belichtungsfleck (42) der ersten Belichtungsfleckposition (90) der ersten Ablenkungsstrecke (AS) einer nächstfolgenden Belichtungseinheit (50) schneidet.

12. Belichtungsanlage nach einem der voranstehenden Ansprüche, **dadurch gekennzeichnet, dass** die durch die letzte Belichtungsfleckposition (90) einer letzten Ablenkungsstrecke (AS) einer Belichtungseinheit (50) verlaufende Referenzgerade (120) den Belichtungsfleck (42) der ersten Belichtungsfleckposition (90) der ersten Ablenkungsstrecke (AS) einer nächstfolgenden Belichtungseinheit (50) schneidet.

13. Belichtungsanlage nach Anspruch 12, **dadurch gekennzeichnet, dass** die erste Belichtungsfleckposition (90) einen Abstand von der Referenzgerade (120) aufweist, der maximal dem halben Durchmesser des Belichtungsflecks (42) der ersten Belichtungsfleckposition (90) entspricht.

14. Belichtungsanlage nach einem der voranstehenden Ansprüche, **dadurch gekennzeichnet, dass** die Ablenkeinheit (68) für jeden der Belichtungsstrahlen (60) einen Spiegelflächenbereich (78) aufweist.

15. Belichtungsanlage nach Anspruch 14, **dadurch gekennzeichnet, dass** die Spiegelflächenbereiche (78) einer Belichtungseinheit (50) gemeinsam bewegbar sind.

16. Belichtungsanlage nach Anspruch 14 oder 15, **dadurch gekennzeichnet, dass** die Spiegelflächenbereiche (78) Teilbereiche einer gemeinsamen Spiegelfläche (74) sind.

17. Belichtungsanlage nach einem der Ansprüche 14 bis 16, **dadurch gekennzeichnet, dass** die Spiegelflächenbereiche (78) relativ zur Auftreffrichtung der Belichtungsstrahlen (60) auf diese verkippbar sind.

18. Belichtungsanlage nach einem der Ansprüche 14 bis 17, **dadurch gekennzeichnet, dass** die Spiegelflächenbereiche (78) ebene Flächenbereiche sind.

19. Belichtungsanlage nach Anspruch 18, **dadurch gekennzeichnet, dass** alle Spiegelflächenbereiche (78) in einer gemeinsamen Ebene liegen.

20. Belichtungsanlage nach Anspruch 18 oder 19, **dadurch gekennzeichnet, dass** die Spiegelflächenbereiche (78), auf die die Belichtungsstrahlen (60) einer Belichtungseinheit (50) auftreffen, in derselben Ebene liegen.

21. Belichtungsanlage nach einem der Ansprüche 14 bis 20, **dadurch gekennzeichnet, dass** die Belichtungseinheit (50) für jeden Belichtungsstrahl (60) mehrere Spiegelflächenbereiche (78) aufweist.

22. Belichtungsanlage nach Anspruch 21, **dadurch gekennzeichnet, dass** die Ablenkeinheit (64) für jeden Belichtungsstrahl (60) mehrere nacheinander eingesetzte Spiegelflächenbereiche (78) aufweist.

23. Belichtungsanlage nach einem der Ansprüche 20 bis 22, **dadurch gekennzeichnet, dass** die mehreren Spiegelflächenbereiche (78) durch Umfangsseiten eines drehbar angeordneten Spiegelkörpers (70) gebildet sind.

24. Belichtungsanlage nach Anspruch 23, **dadurch gekennzeichnet, dass** der Spiegelkörper (70) um eine Achse (72) rotierend angeordnet ist.

25. Belichtungsanlage nach Anspruch 24, **dadurch gekennzeichnet, dass** die Spiegelflächenbereiche (78) im gleichen radialen Abstand um die Achse (72) angeordnet sind.

26. Belichtungsanlage nach Anspruch 24 oder 25, **dadurch gekennzeichnet, dass** der Spiegelkörper (70) mit konstanter Drehzahl um seine Achse (72) rotiert.

27. Belichtungsanlage nach einem der voranstehenden Ansprüche, **dadurch gekennzeichnet, dass** die Strahlungsaustrittsbereiche (54) Enden von Lichtleitfasern (114) sind.

28. Belichtungsanlage nach Anspruch 27, **dadurch gekennzeichnet, dass** jeder Lichtleitfaser (114) eine Strahlungsquelle (112) zugeordnet ist.

29. Belichtungsanlage nach Anspruch 28, **dadurch gekennzeichnet, dass** die Strahlungsquelle (112) ein Laser ist.

30. Belichtungsanlage nach Anspruch 29, **dadurch gekennzeichnet, dass** die Strahlungsquelle (112) ein Halbleiterlaser ist.

31. Belichtungsanlage nach einem der voranstehenden Ansprüche, **dadurch gekennzeichnet, dass** Strahlungsquellen (112) der Belichtungseinrichtung (30) in einer von der Belichtungseinrichtung (30) getrennt angeordneten Strahlungserzeugungseinheit (110) angeordnet sind.

## Claims

1. Exposure apparatus for producing exposed structures (26) in a photosensitive layer (24) disposed on an object (22), comprising an object carrier (14) accommodating the object (22) and an exposure device (30), the object carrier (14) and the exposure device (30) being movable in relation to one another in a direction of advance (16) and it being possible for exposure spots (42) to be produced by the exposure device (30) on the photosensitive layer (24) in a position-controlled manner, transversely with respect to the direction of advance (16), the exposure device (30) having at least one exposure unit (50) with a series (52) of radiation exit regions (54) which are disposed successively in a series direction (53) and from which exposure beams (56) emerge, with each of which beams, directed through an imaging optical system (102), an exposure spot (42) can be produced on the photosensitive layer (24) and each of which beams can be deflected by a deflection unit (64) in a direction of deflection (68) running at an angle with respect to the direction of advance (16) such that each exposure beam (60) can be used to produce exposure spots (42) that at least partly overlap one another in a multiplicity of successive exposure spot positions (90) in the direction of deflection (68),
**characterized in that** each exposure spot (42) can be deflected by the deflection unit transversely with respect to the series direction (53) and **in that** the exposure spot (42) of the final exposure spot position (90) of one path of deflection (AS) and the exposure spot (42) of the first exposure spot position (90) of the next-following path of deflection (AS) are disposed in such a way with respect to a straight reference line (120) running parallel to the direction of advance (16) that the straight reference line (120) intersects the exposure spots (42) produced in these exposure spot positions (90).

2. Exposure apparatus according to Claim 1, **characterized in that** the exposure spots (42) of successive exposure beams (60) are movable along directions of deflection (68) that are parallel to one another.

3. Exposure apparatus according to one of the preceding claims, **characterized in that** the exposure beams (60) of the at least one exposure unit (50) can be deflected simultaneously and to the same extent by the deflection unit (64).

4. Exposure apparatus according to one of the preceding claims, **characterized in that** the exposure beams (60) of an exposure unit (50) are aligned substantially parallel to one another when they impinge on the photosensitive layer (24).

5. Exposure apparatus according to one of the preceding claims, **characterized in that** the movement of each exposure spot (42) produced by an exposure beam (66) in the respective direction of deflection (68) takes place over a path of deflection (AS) which is approximately the same size for each exposure beam (66) of the exposure unit (50).

6. Exposure apparatus according to one of the preceding claims, **characterized in that** a straight reference line (120) running parallel to the direction of advance (16) through the final exposure spot position (90) of one path of deflection (AS) intersects the exposure spot (42) of a first exposure spot position (90) of a next-following path of deflection (AS).

7. Exposure apparatus according to Claim 6, **characterized in that** the first exposure spot position (90) of the next-following path of deflection (AS) is at a distance from the straight reference line (120) that corresponds at most to half the diameter of the exposure spot (42).

8. Exposure apparatus according to one of the preceding claims, **characterized in that** a plurality of exposure units (50) are provided, the exposure units (50) being disposed at a distance from one another in the direction of deflection (68).

9. Exposure apparatus according to Claim 8, **characterized in that** the directions of deflection (68) of the plurality of exposure units (50) run substantially parallel to one another.

10. Exposure apparatus according to Claim 8 or 9, **characterized in that** the series directions (53) of the plurality of exposure units (50) run substantially parallel to one another.

11. Exposure apparatus according to one of Claims 8 to 10, **characterized in that** the plurality of exposure units (50) are disposed with respect to a straight reference line (120) running parallel to the direction of advance (16) in such a way that the straight reference line (120) intersects the exposure spot (42) of the final exposure spot position (90) of the final deflecting path (AS) of one exposure unit (50) and the exposure spot (42) of the first exposure spot position (90) of the first deflecting path (AS) of a next-following exposure unit (50).

12. Exposure apparatus according to one of the preceding claims, **characterized in that** the straight reference line (120) running through the final exposure spot position (90) of a final deflecting path (AS) of one exposure unit (50) intersects the exposure spot (42) of the first exposure spot position (90) of the first deflecting path (AS) of a next-following exposure unit (50).

13. Exposure apparatus according to Claim 12, **characterized in that** the first exposure spot position (90) is at a distance from the straight reference line (120) that corresponds at most to half the diameter of the exposure spot (42) of the first exposure spot position (90).

14. Exposure apparatus according to one of the preceding claims, **characterized in that** the deflection unit (68) has a reflective surface region (78) for each of the exposure beams (60).

15. Exposure apparatus according to Claim 14, **characterized in that** the reflective surface regions (78) of an exposure unit (50) are jointly movable.

16. Exposure apparatus according to Claim 14 or 15, **characterized in that** the reflective surface regions (78) are partial regions of a common reflective surface (74).

17. Exposure apparatus according to one of Claims 14 to 16, **characterized in that** the reflective surface regions (78) can be tilted in relation to the direction of impingement of the exposure beams (60) on these regions.

18. Exposure apparatus according to one of Claims 14 to 17, **characterized in that** the reflective surface regions (78) are planar surface regions.

19. Exposure apparatus according to Claim 18, **characterized in that** all the reflective surface regions (78) lie in a common plane.

20. Exposure apparatus according to Claim 18 or 19, **characterized in that** the reflective surface regions (78) on which the exposure beams (60) of an exposure unit (50) impinge lie in the same plane.

21. Exposure apparatus according to one of Claims 14 to 20, **characterized in that** the exposure unit (50) has a plurality of reflective surface regions (78) for each exposure beam (60).

22. Exposure apparatus according to Claim 21, **characterized in that** the deflection unit (64) has a plurality of reflective surface regions (78) that are used one after the other for each exposure beam (60).

23. Exposure apparatus according to one of Claims 20 to 22, **characterized in that** the plurality of reflective surface regions (78) are formed by circumferential sides of a rotatably disposed reflective body (70).

24. Exposure apparatus according to Claim 23, **characterized in that** the reflective body (70) is disposed such that it rotates about an axis (72).

25. Exposure apparatus according to Claim 24, **characterized in that** the reflective surface regions (78) are disposed around the axis (72) at the same radial distance.

26. Exposure apparatus according to Claim 24 or 25, **characterized in that** the reflective body (70) rotates about its axis (72) at a constant speed.

27. Exposure apparatus according to one of the preceding claims, **characterized in that** the radiation exit regions (54) are ends of optical fibres (114).

28. Exposure apparatus according to Claim 27, **characterized in that** a radiation source (112) is associated with each optical fibre (114).

29. Exposure apparatus according to Claim 28, **characterized in that** the radiation source (112) is a laser.

30. Exposure apparatus according to Claim 29, **characterized in that** the radiation source (112) is a semiconductor laser.

31. Exposure apparatus according to one of the preceding claims, **characterized in that** radiation sources (112) of the exposure device (30) are disposed in a radiation generating unit (110) located separately from the exposure device (30).

## Revendications

1. Installation d'exposition pour la génération de structures (26) exposées dans une couche photosensible (24) disposée sur un objet (22), comprenant un support d'objet (14) recevant l'objet (22) et un dispositif d'exposition (30), le support d'objet (14) et le dispositif d'exposition (30) étant déplaçables l'un par rapport à l'autre dans une direction d'avancée (16), et des taches d'exposition (42) pouvant être générées avec commande de position sur la couche photosensible (24) transversalement à la direction d'avancée (16) au moyen du dispositif d'exposition (30), le dispositif d'exposition (30) comportant au moins une unité d'exposition (50) avec une rangée (52) de zones de sortie de rayonnement (54) disposées successivement dans une direction de rangée (53), d'où sortent des faisceaux d'exposition (56), par chacun desquels une tache d'exposition (42) peut être générée sur la couche photosensible (24) après traversée d'une optique d'imagerie (102), et dont chacun peut être dévié par une unité de déviation (64) dans une direction de déviation (68) oblique par rapport à la direction d'avancée (16), si bien que des taches d'exposition (42) qui se chevauchent au moins partiellement peuvent être générées par chaque faisceau d'exposition (60) dans une pluralité de positions de taches d'exposition (90) successives dans la direction de déviation (68),
**caractérisée en ce que** chaque tache d'exposition (42) peut être déviée par l'unité de déviation transversalement à la direction de rangée (53), et **en ce que** la tache d'exposition (42) de la dernière position de tache d'exposition (90) du premier trajet de déviation (AS) et la tache d'exposition (42) de la première position de tache d'exposition (90) du trajet de déviation (AS) immédiatement suivant sont disposées par rapport à une droite de référence (120) parallèle à la direction d'avancée (16) de telle manière que la droite de référence (120) coupe les taches d'exposition (42) générées dans ces positions de tache d'exposition (90).

2. Installation d'exposition selon la revendication 1, **caractérisée en ce que** les taches d'exposition (42) de faisceaux d'exposition (60) successifs sont déplaçables dans des directions de déviation (68) parallèles l'une à l'autre.

3. Installation d'exposition selon l'une des revendications précédentes, **caractérisée en ce que** les faisceaux d'exposition (60) de l'unité ou des unités d'exposition (50) peuvent être déviés simultanément et dans une même mesure par l'unité de déviation (64).

4. Installation d'exposition selon l'une des revendications précédentes, **caractérisée en ce que** les faisceaux d'exposition (60) d'une unité d'exposition (50) sont incidents sur la couche photosensible (24) en étant alignés sensiblement parallèlement les uns aux autres.

5. Installation d'exposition selon l'une des revendications précédentes, **caractérisée en ce que** le déplacement de chaque tache d'exposition (42) générée par un faisceau d'exposition (66) dans la direction de déviation (68) correspondante est réalisé sur un trajet de déviation (AS) de longueur sensiblement égale pour chaque faisceau d'exposition (66) de l'unité d'exposition (50).

6. Installation d'exposition selon l'une des revendications précédentes, **caractérisée en ce qu'**une droite de référence (120) parallèle à la direction d'avancée (16) passant par la dernière position de tache d'exposition (90) d'un trajet de déviation (AS) coupe la tache d'exposition (42) d'une première position de tache d'exposition (90) d'un trajet de déviation (AS) immédiatement suivant.

7. Installation d'exposition selon la revendication 6, **caractérisée en ce que** la première position de tache d'exposition (90) du trajet de déviation (AS) immédiatement suivant présente un espacement à la droite de référence (120), qui correspond au plus à un demi-diamètre de la tache d'exposition (42).

8. Installation d'exposition selon l'une des revendications précédentes, **caractérisée en ce que** plusieurs unités d'exposition (50) sont prévues, lesdites unités d'exposition (50) étant espacées l'une de l'autre dans la direction de déviation (68).

9. Installation d'exposition selon la revendication 8, **caractérisée en ce que** les directions de déviation (68) des multiples unités d'exposition (50) sont sensiblement parallèles entre elles.

10. Installation d'exposition selon la revendication 8 ou 9, **caractérisée en ce que** les directions de rangée (53) des multiples unités d'exposition (50) sont sensiblement parallèles entre elles.

11. Installation d'exposition selon l'une des revendications 8 à 10, **caractérisée en ce que** les multiples unités d'exposition (50) sont disposées par rapport à une droite de référence (120) parallèlement à la direction d'avancée (16) de telle manière que la droite de référence (120) coupe la tache d'exposition (42) de la dernière position de tache d'exposition (90) du dernier trajet de déviation (AS) d'une unité d'exposition (50) et la tache d'exposition (42) de la première position de tache d'exposition (90) du premier trajet de déviation (AS) d'une unité d'exposition (50) immédiatement suivante.

12. Installation d'exposition selon l'une des revendications précédentes, **caractérisée en ce que** la droite de référence (120) passant par la dernière position de tache d'exposition (90) d'un dernier trajet de déviation (AS) d'une unité d'exposition (50) coupe la tache d'exposition (42) de la première position de tache d'exposition (90) du premier trajet de déviation (AS) d'une unité d'exposition (50) immédiatement suivante.

13. Installation d'exposition selon la revendication 12, **caractérisée en ce que** la première position de taches d'exposition (90) présente un espacement à la droite de référence (120), qui correspond au plus au demi-diamètre de la tache d'exposition (42) de la première position de tache d'exposition (90).

14. Installation d'exposition selon l'une des revendications précédentes, **caractérisée en ce que** l'unité de déviation (68) présente une zone de surface réfléchissante (78) pour chacun des faisceaux d'exposition (60).

15. Installation d'exposition selon la revendication 14, **caractérisée en ce que** les zones à surface réfléchissante (78) d'une unité d'exposition (50) sont déplaçables conjointement.

16. Installation d'exposition selon la revendication 14 ou 15, **caractérisée en ce que** les zones à surface réfléchissante (78) sont des zones partielles d'une surface réfléchissante (74) commune.

17. Installation d'exposition selon l'une des revendications 14 à 16, **caractérisée en ce que** les zones à surface réfléchissante (78) peuvent être pivotées vers les faisceaux d'exposition (60) par rapport à la direction d'incidence de ceux-ci.

18. Installation d'exposition selon l'une des revendications 14 à 17, **caractérisée en ce que** les zones à surface réfléchissante (78) sont des zones de surface planes.

19. Installation d'exposition selon la revendication 18, **caractérisée en ce que** toutes les zones à surface réfléchissante (78) sont situées sur un plan commun.

20. Installation d'exposition selon la revendication 18 ou 19, **caractérisée en ce que** les zones à surface réfléchissante (78), sur lesquelles les faisceaux d'exposition (60) d'une unité d'exposition (50) sont incidents, sont situées sur le même plan.

21. Installation d'exposition selon l'une des revendications 14 à 20, **caractérisée en ce que** l'unité d'exposition (50) comprend pour chaque faisceau d'exposition (60) plusieurs zones à surface réfléchissante (78).

22. Installation d'exposition selon la revendication 21, **caractérisée en ce que** l'unité de déviation (64) comprend pour chaque faisceau d'exposition (60) plusieurs zones à surface réfléchissante (78) mises en place l'une derrière l'autre.

23. Installation d'exposition selon l'une des revendications 20 à 22, **caractérisée en ce que** les multiples zones à surface réfléchissante (78) sont formées par des faces périphériques d'un corps de miroir (70) rotatif.

24. Installation d'exposition selon la revendication 23, **caractérisée en ce que** le corps de miroir (70) est rotatif autour d'un axe (72).

25. Installation d'exposition selon la revendication 24, **caractérisée en ce que** les zones à surface réfléchissante (78) sont disposées avec le même espacement radial autour de l'axe (72).

26. Installation d'exposition selon la revendication 24 ou 25, **caractérisée en ce que** le corps de miroir (70) tourne à vitesse constante autour de son axe (72).

27. Installation d'exposition selon l'une des revendications précédentes, **caractérisée en ce que** les zones de sortie de rayonnement (54) sont des extrémités de fibres optiques (114).

28. Installation d'exposition selon la revendication 27, **caractérisée en ce qu'**à chaque fibre optique (114) est associée une source de rayonnement (112).

29. Installation d'exposition selon la revendication 28, **caractérisée en ce que** la source de rayonnement (112) est un laser.

30. Installation d'exposition selon la revendication 29, **caractérisée en ce que** la source de rayonnement (112) est un laser à semi-conducteur.

31. Installation d'exposition selon l'une des revendications précédentes, **caractérisée en ce que** les sources de rayonnement (112) du dispositif d'exposition (30) sont disposées dans une unité de génération de rayonnement (110) séparée du dispositif d'exposition (30).
